Europäisches Patentamt

European Patent Office

Office européen des brevets

(19)

(11) **EP 0 826 254 B1**

(12) **EUROPÄISCHE PATENTSCHRIFT**

(45) Veröffentlichungstag und Bekanntmachung des Hinweises auf die Patenterteilung:
**30.06.1999 Patentblatt 1999/26**

(21) Anmeldenummer: **96913433.7**

(22) Anmeldetag: **18.04.1996**

(51) Int Cl.6: **H01S 3/00**, G02F 1/35, G01J 9/02

(86) Internationale Anmeldenummer:
**PCT/DE96/00725**

(87) Internationale Veröffentlichungsnummer:
**WO 96/33535 (24.10.1996 Gazette 1996/47)**

(54) **OPTISCHER FREQUENZGENERATOR**

OPTICAL FREQUENCY GENERATOR

GENERATEUR DE FREQUENCES OPTIQUES

(84) Benannte Vertragsstaaten:
**BE CH DE ES FR GB IT LI NL**

(30) Priorität: **19.04.1995 DE 19514386**

(43) Veröffentlichungstag der Anmeldung:
**04.03.1998 Patentblatt 1998/10**

(73) Patentinhaber: **Heinrich-Hertz-Institut für Nachrichtentechnik Berlin GmbH 10587 Berlin (DE)**

(72) Erfinder:
• **VON HELMOLT, Clemens**
  **D-12205 Berlin (DE)**
• **KRÜGER, Udo**
  **D-12161 Berlin (DE)**

(74) Vertreter: **Rudolph, Margit et al**
**Heinrich-Hertz-Institut für Nachrichtentechnik Berlin GmbH,**
**Gemeinsamer Patentservice,**
**Hausvogteiplatz 5-7**
**10117 Berlin (DE)**

(56) Entgegenhaltungen:
**WO-A-93/00740**

• **IEEE JOURNAL OF QUANTUM ELECTRONICS, Bd. 29, Nr. 10, 1.Oktober 1993, Seiten 2693-2701, XP000423090 MOTONOBU KOUROGI ET AL: "WIDE-SPAN OPTICAL FREQUENCY COMB GENERATOR FOR ACCURATE OPTICAL FREQUENCY DIFFERENCE MEASUREMENT"**
• **OPTICS LETTERS, OCT. 1988, USA, Bd. 13, Nr. 10, ISSN 0146-9592, Seiten 901-903, XP002010617 GOUVEIA-NETO A S ET AL: "Subpicosecond-pulse generation through cross-phase-modulation-induced modulational instability in optical fibers"**
• **IEEE PHOTONICS TECHNOLOGY LETTERS, Bd. 6, Nr. 3, 1.März 1994, Seiten 365-368, XP000439711 MORIOKA T ET AL: "MULTI-WDM-CHANNEL, GBIT/S PULSE GENERATION FROM A SINGLE LASER SOURCE UTILIZING LD-PUMPED SUPERCONDINUUM IN OPTICAL FIBER"**
• **IEEE PHOTONICS TECHNOLOGY LETTERS, Bd. 5, Nr. 6, 1.Juni 1993, Seiten 721-725, XP000384067 KEANG-PO HO ET AL: "OPTICAL FREQUENCY COMB GENERATOR USING PHASE MODULATION IN AMPLIFIED CIRCULATING LOOP"**

**Beschreibung**

Die Erfindung betrifft einen optischen Frequenzgenerator mit einer Referenzlichtquelle, mit einem Frequenzsender, mit einem optischen Kammgenerator zum Erzeugen einer Vielzahl optischer Frequenzen und mit einer Steuerelektronik.

Ein derartiger optischer Frequenzgenerator ist aus der US 5,233,462 bekannt. Bei diesem optischen Frequenzgenerator ist Ausgangslicht eines Lasers als eine intensive monochromatische Referenzlichtquelle einem optischen Kammgenerator eingespeist, der mehrere optische parametrische Oszillatoren aufweist. Die parallel angeordneten optischen parametrischen Oszillatoren sind so aufeinander abgestimmt, daß die sogenannten Signal- oder Idler-Wellen der einzelnen optischen parametrischen Oszillatoren einen groben Frequenzkamm mit großen Frequenzabständen bilden. Eine der beiden Ausgangswellen, beispielsweise die Signalwelle, jedes optischen parametrischen Oszillators ist einem zugeordneten, von einem Mikrowellensender als Frequenzsender mit einer Frequenz beaufschlagten elektro-optischen Modulator des Kammgenerators eingespeist, mit dem zu der Mittenfrequenz der eingespeisten Signalwelle eine Anzahl von Seitenbändern mit einer der eingespeisten Mikrowellenfrequenz entsprechenden Frequenzabstand erzeugbar sind.

Dieser optische Frequenzgenerator weist zwar durch den optisch-parametrischen Prozeß bei fester Frequenz der Referenzlichtquelle einen verhältnismäßig großen Abstimmbereich auf, allerdings ist er aufgrund der benötigten Anzahl von optischen parametrischen Oszillatoren, elektro-optischen Modulatoren sowie durch das Erfordernis der genauen Regelung des Frequenzteilungsverhältnisses jedes einzelnen optischen parametrischen Oszillators für eine Frequenzmessung apparativ äußerst aufwendig. Weiterhin ist zum Betrieb der optischen parametrischen Oszillatoren eine sehr intensive Referenzlichtquelle zur Generierung des optischen parametrischen Prozesses notwendig. Weiterhin ist zur Frequenzbestimmung einer unbekannten Lichtquelle eine Vormessung mit einem Wellenlängenmesser notwendig.

Der vorbekannte optische Frequenzgenerator dient in einer Anwendung als optische Frequenzmeßvorrichtung. Hierzu sind bei genauer Kenntnis der Frequenz der die optischen parametrischen Oszillatoren speisenden Frequenzkomponente der Referenzlichtquelle, des Teilungsverhältnisses der optischen parametrischen Oszillatoren sowie der den elektro-optischen Modulatoren eingespeisten Mikrowellenfrequenz eine Frequenzmessung von Prüflicht unbekannter Frequenz durchführbar. Dazu wird nach einer herkömmlichen relativ groben Wellenlängenmessung des Prüflichtes die Messung eines Schwebungssignales zwischen der unbekannten Frequenz und dem nächstbenachbarten Seitenband eines optischen parametrischen Oszillators durchgeführt. Die genaue Position des Seitenbandes und damit die absolute Frequenz ist durch Variation der den elektro-optischen Modulatoren eingespeisten Mikrowellenfrequenz und Messen der Veränderung der Schwebungsfrequenz, die mit der Ordnung des Seitenbandes korreliert ist, bestimmbar.

Der Erfindung liegt die Aufgabe zugrunde, einen optischen Frequenzgenerator der eingangs genannten Art zu schaffen, der mit einem verhältnismäßig geringen apparativen Aufwand eine Erzeugung eines abstimmbaren Frequenzkammes mit präzise bestimmbaren Frequenzlinien gestattet.

Diese Aufgabe wird erfindungsgemäß dadurch gelöst, daß der Kammgenerator eine mit einem mittels der Steuerelektronik in der Frequenz einstellbaren Ausgangssignal des Frequenzsenders sowie mit einem Regelsignal frequenzmodulierbare Lichtquelle und ein von Ausgangslicht der Lichtquelle beaufschlagtes, optisch nichtlineares Bauelement aufweist, wobei mit der Lichtquelle und dem optisch nichtlinearen Bauelement um eine durch das Regelsignal einstellbare Mittenfrequenz eine Vielzahl von Seitenbändern mit einem Vielfachen der Frequenz des eingespeisten Ausgangssignales des Frequenzsenders entsprechenden Frequenzabständen erzeugbar sind, und daß Ausgangslicht des Kammgenerators mit Ausgangslicht der Referenz lichtquelle in einer Überlagerungseinheit zur Erzeugung des Regelsignales überlagerbar ist.

Durch die Überlagerung des Ausgangslichts des Kammgenerators mit dem sehr schmalbandigen Ausgangslicht einer zweckmäßigerweise wenig intensiven Referenzlichtquelle sind die Frequenzen der einzelnen Seitenbänder des Frequenzkammes genau bestimmbar und die Mittenfrequenz des Kammgenerators mit dem Regelsignal elektronisch genau einstellbar. Der Frequenzabstand zwischen den Seitenbändern ist mittels der Sendefrequenz des Frequenzsenders einstellbar, so daß auch die Weite des Kammes definiert elektronisch veränderbar ist. Somit sind die Lage und die Weite des Frequenzkammes mit Frequenzsignalen beispielsweise im Bereich von Radiofrequenzen oder Mikrowellen bei Kopplung an die sehr schmalbandige Referenzlichtquelle bekannter Frequenz elektronisch definiert einstellbar, ohne daß es einer aufwendigen optischen Justage oder optischen Wellenlängenmessungen bedarf.

In einer vorteilhaften Ausgestaltung des optischen Frequenzgenerators verfügt der Kammgenerator über einen Halbleiterlaser, dessen Steuerstrom zum einen von einem Mittenfrequenzregler als Überlagerungseinheit in seinem Mittelwert gesteuert und zum anderen um den Mittelwert mit einer Mikrowellenfrequenz aus dem Frequenzsender moduliert ist. Das Ausgangslicht des Halbleiterlasers weist dadurch einige Seitenbänder um die Mittenfrequenz auf, wobei die Spektralbreite des Halbleiterlasers in Abhängigkeit der Anzahl der erzeugten Seitenbänder etwa einem Zehnfachen bis Hundertfachen der eingespeisten Mikrowellenfrequenz entspricht.

Das Ausgangslicht des Halbleiterlasers ist einem Superkontinuumsgenerator mit einem Faserverstärker und einer Lichtleitfaser eingespeist, mit dem über optisch nichtlineare Effekte das Ausgangssignal des Halbleiterlasers typischerweise um einen Faktor 200 als Kammspektrum vergrößerbar ist, wobei durch den passiv wirkenden Superkontinuumsgenerator die Frequenzabstände zwischen den Seitenbändern der dem Halbleiterlaser eingespeisten Mikrowellenfrequenz entsprechen, während die Lage des Frequenzkammes durch die über den Mittenfrequenzregler einstellbare Mittenfrequenz des Halbleiterlasers festgelegt ist.

In einer Abwandlung der vorgenannten vorteilhaften Ausgestaltung ist auf den Mittenfrequenzregler verzichtet. Statt dessen ist die Mittenfrequenz des Halbleiterlasers direkt einstellbar und die absolute Lage eines Seitenbandes des optischen Kammgenerators mittels mehrerer Messungen der Verschiebefrequenz zwischen dem Ausgangslicht der Referenzlichtquelle und einem weiteren Seitenband des Kammlichtgenerators bestimmt. Auf diese Weise ist ein apparativer hoher Aufwand bei hohen Eingangsfrequenzen des Mittenfrequenzreglers vermieden.

Weitere Vorteile und zweckmäßige Ausgestaltungen der Erfindung sind Gegenstand der Unteransprüche sowie der nachfolgenden Beschreibung von Ausführungsbeispielen unter Bezug auf die Zeichnung. Es zeigen:

Fig. 1 in einem Blockschaltbild ein Ausführungsbeispiel eines optischen Frequenzgenerators in der Verwendung zum Messen von unbekannten Lichtfrequenzen,

Fig. 2 ein Ausführungsbeispiel eines Kammgenerators des optischen Frequenzgenerators gemäß Fig. 1,

Fig. 3 ein Ausführungsbeispiel eines Mittenfrequenzreglers als Überlagerungseinheit des optischen Frequenzgenerators gemäß Fig. 1,

Fig. 4 eine zweckmäßige Ausgestaltung eines Überlagerungsempfängers zum Messen unbekannter optischer Frequenzen mittels des Frequenzgenerators gemäß Fig. 1,

Fig. 5, 6 einen Ablaufalgorithmus zum Durchführen einer Frequenzmessung mit dem optischen Frequenzgenerator gemäß Fig. 1,

Fig. 7 in einem Blockschaltbild ein weiteres Ausführungsbeispiel eines optischen Frequenzgenerators in der Verwendung zum Messen von unbekannten Lichtfrequenzen,

Fig. 8 eine weitere zweckmäßige Ausgestaltung einer Überlagerungseinheit zum Messen unbekannter optischer Frequenzen mittels des optischen Frequenzgenerators gemäß Fig. 7,

Fig. 9 ein schaltbares Zwischenfrequenzfilter der Überlagerungseinheit gemäß Fig. 8 und

Fig. 10, 11, 12 einen weiteren Ablaufalgorithmus zum Durchführen einer Frequenzmessung mit dem optischen Frequenzgenerator gemäß Fig. 7.

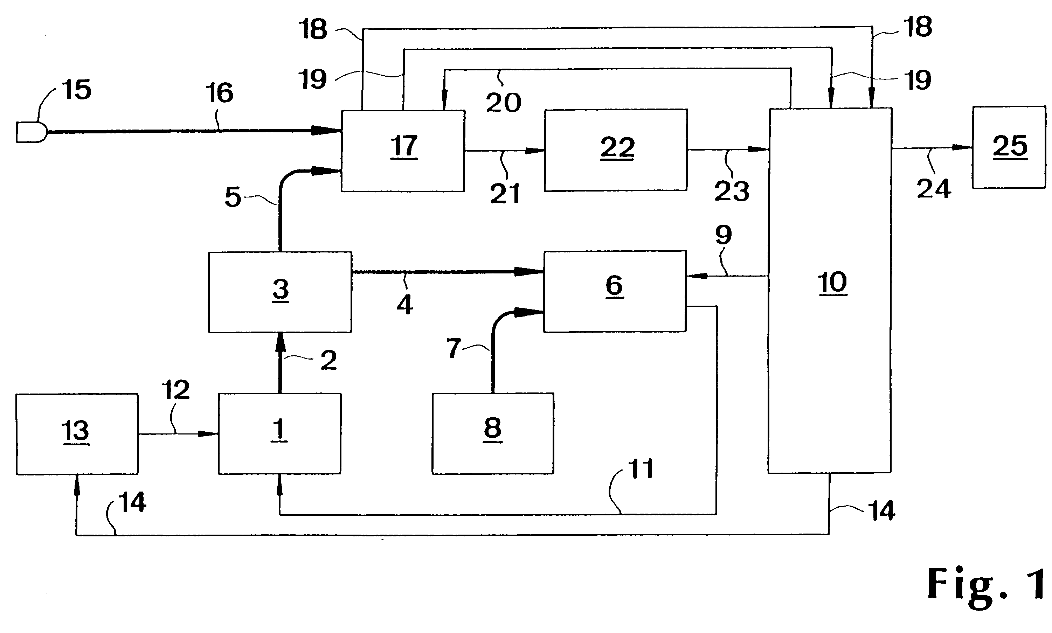

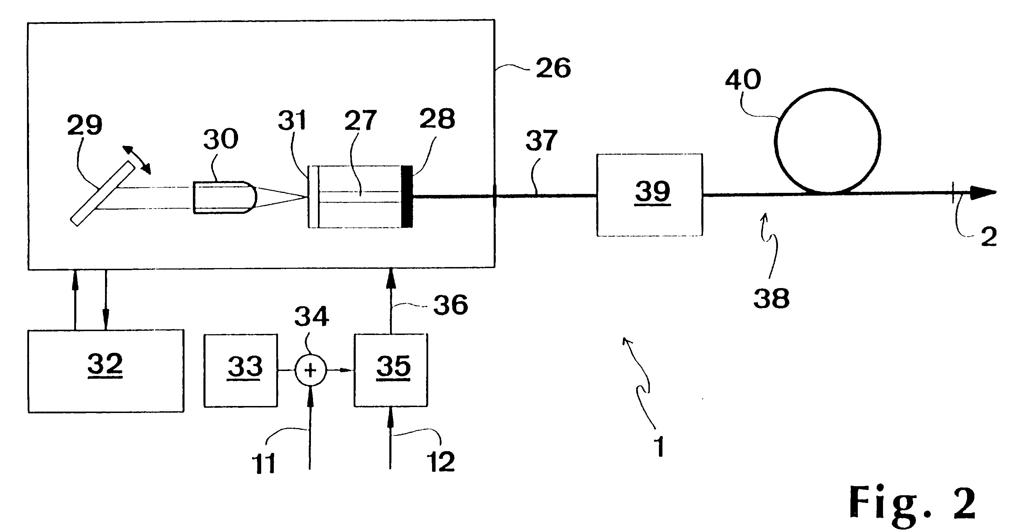

Fig. 1 zeigt in einem Blockschaltbild ein Ausführungsbeispiel eines optischen Frequenzgenerators in der Verwendung zum Bestimmen unbekannter optischer Frequenzen. Der optische Frequenzgenerator weist einen in einer bevorzugten Ausgestaltung in Fig. 2 näher beschriebenen Kammgenerator 1 auf, mit dem um eine Mittenfrequenz eine Vielzahl von Seitenbändern erzeugbar ist. Das Ausgangslicht des Kammgenerators 1 ist über einen Kammlichtleiter 2 einem Strahlteiler 3 zugeführt, mit dem das Ausgangslicht des Kammgenerators 1 in einen ersten Teilkammlichtleiter 4 und einen zweiten Teilkammlichtleiter 5 aufteilbar ist.

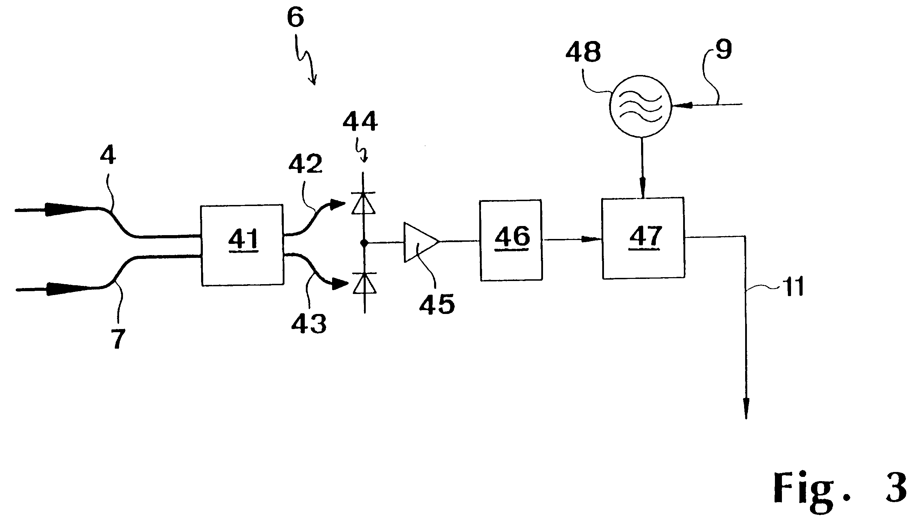

Das in dem ersten Teilkammlichtleiter 4 geführte Ausgangslicht des Kammgenerators 1 ist einem in einer Ausgestaltung in Fig. 3 näher erläuterten Mittenfrequenzregler 6 als Überlagerungseinheit zusammen mit in einem Referenzlichtleiter 7 geführtem Ausgangslicht einer stabilisierten Referenzlichtquelle 8 mit einer sehr schmalbandigen Referenzlinie einspeisbar. Dem Mittenfrequenzregler 6 ist weiterhin über eine Differenzsteuerleitung 9 ein von einer Steuerelektronik 10 erzeugtes Differenzsteuersignal einspeisbar, das einer durch den Mittenfrequenzregler 6 einzuhaltenden Differenz zwischen der Referenzlinie der Referenzlichtquelle 8 und einer Frequenzkomponente des Ausgangslichtes des Kammgenerators 1 entspricht. Dem Kammgenerator 1 ist über eine Regelleitung 11 ein von dem Mittenfrequenzregler 6 erzeugtes Regelsignal zum Einstellen der Mittenfrequenz rückführbar.

Dem Kammgenerator 1 ist weiterhin über eine Mikrowellenleitung 12 das Ausgangssignals eines als Frequenzsender dienenden Mikrowellensenders 13 einspeisbar, mit dem der Frequenzabstand zwischen benachbarten Seitenbändern in dem Ausgangslicht des Kammgenerators 1 einstellbar ist. Die Sendefrequenz des Mikrowellensenders 13 ist über eine Mikrowellensteuerleitung 14 mit der Steuerelektronik 10 einstellbar.

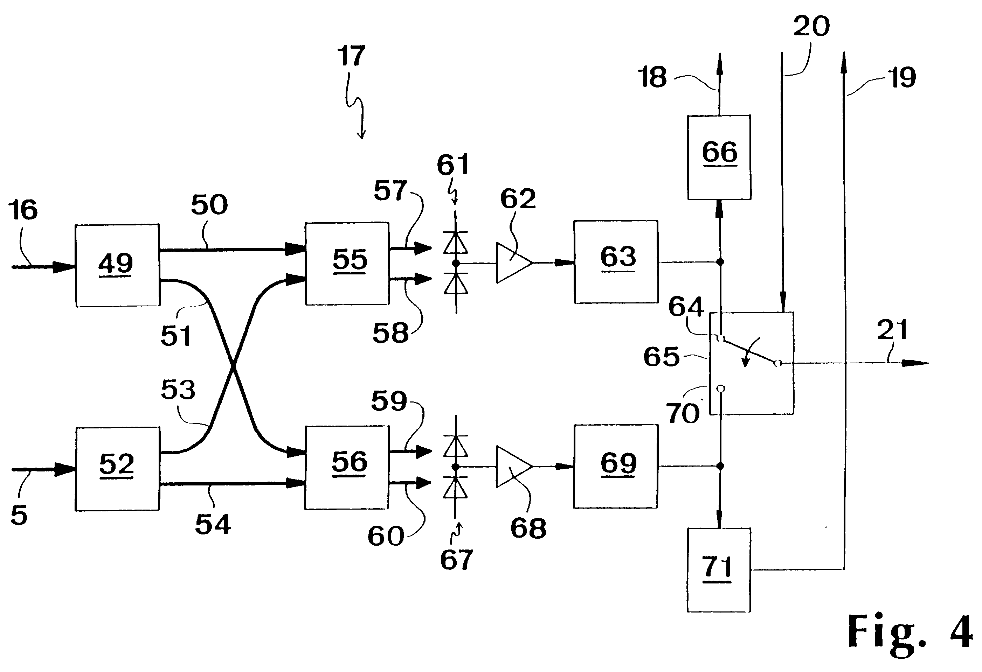

Das in dem zweiten Teilkammlichtleiter 5 geführte Ausgangslicht des Kammgenerators 1 ist bei dem Anwendungsbeispiel des optischen Frequenzgenerators gemäß Fig. 1 mit über einen Eingangskoppler 15 in einen Eingangslichtleiter 16 eingekoppelten und geführten Prüflicht unbekannter Frequenz in einen Überlagerungsempfänger 17 überlagerbar, der in einem Ausführungsbeispiel in Fig. 4 näher erläutert ist. Über eine erste Leistungsleitung 18, eine zweite Leistungsleitung 19 und eine Schaltleitung 20 zwischen dem Überlagerungsempfänger 17 und der Steuerelektronik 10 gesteuert ist über eine Schwebungssignalleitung 21 ein der Frequenzdifferenz zwischen einer Frequenzkomponente des Ausgangslichtes des Kammgenerators 1 und dem Prüflicht entsprechendes Schwebungsfrequenzsignal in einen Frequenzzähler 22 einspeisbar. Über eine Signalleitung 23 ist ein von dem Frequenzzähler 22 bestimmter Wert der Schwebungsfrequenz der Steuerelektronik 10 zuführbar.

Ein in einer weiter unten näher erläuterten Verfahrensweise bestimmter Frequenzwert des Prüflichtes ist von der Steuerelektronik 10 über eine Anzeigeleitung 24 einer Frequenzanzeigevorrichtung 25 einspeisbar, mit der die Frequenz des Prüflichtes ausgebbar ist.

Fig. 2 zeigt ein zweckmäßiges Ausführungsbeispiel eines Kammgenerators 1, über den der optische Frequenzgenerator gemäß Fig. 1 verfügt. Der Kammgenerator gemäß Fig. 2 weist einen Halbleiterlaser 26 auf, dessen aktives Medium 27 zwischen einem mit Stickstoffionen bestrahlten Auskoppelfenster 28 als sättigbaren Absorber zum Erzeugen von Pulsen sehr hoher Spitzenleistung über Modenkopplung und einem Reflexionsgitter 29 angeordnet ist. Das Reflexionsgitter 29 ist zum Einstellen der Wellenlänge mit einer in Fig. 2 nicht dargestellten Verstellvorrichtung in bezug auf die Strahlachse des Resonators kippbar.

Das Auskoppelfenster 28 und das Reflexionsgitter 29 bilden einen externen Resonator des Halbleiterlasers 26, in dessen Strahlengang weiterhin eine Aufweitoptik 30 zum großflächigen Ausleuchten des Reflexionsgitters 29 sowie ein an das aktive Medium 27 resonatorinnenseitig angefügtes antireflexbeschichtetes Austrittsfenster 31 vorgesehen sind.

Der Halbleiterlaser 26 ist mit einem Temperaturregler 32 temperaturstabilisiert, wobei die Betriebstemperatur des Halbleiterlasers 26 mit dem Temperaturregler 32 beispielsweise zum Durchstimmen der Laserwellenlänge einstellbar ist.

Zur Ansteuerung des Halbleiterlasers 26 ist eine Gleichstromquelle 33 vorgesehen, deren Ausgangsstrom einem Eingang einer Addierschaltung 34 zugeführt ist. An den zweiten Eingang der Addierschaltung 34 ist die mit dem Mittenfrequenzregler 6 verbundene Regelleitung 11 angeschlossen. Mit der Addierschaltung 34 ist der von der Gleichstromquelle 33 gelieferte Gleichstrom mit dem Regelsignal in der Regelleitung 11 in seiner Stärke veränderbar.

Der Ausgangsstrom der Addierschaltung 34 ist einer Lasersteuerschaltung 35 zugeführt, der weiterhin über die Mikrowellenleitung 12 das Ausgangssignal des Mikrowellensenders 13 eingespeist ist. Der über eine Lasersteuerleitung 36 aus der Lasersteuerschaltung 35 dem Halbleiterlaser 26 zuführbare Steuerstrom ist mit der Sendefrequenz des Mikrowellensenders 13 moduliert, so daß das in einem Laserlichtleiter 37 geführte Ausgangslicht des Halbleiterlasers 26 neben einer Mittenfrequenz Seitenbänder mit einem der Sendefrequenz des Mikrowellensenders 13 entsprechenden Frequenzabstand aufweist.

Das in dem Laserlichtleiter 37 geführte Ausgangslicht des Halbleiterlasers 26 ist einem Superkontinuumgenerator 38 eingespeist, der einen Erbium-dotierten Faserverstärker 39 sowie eine Superkontinuumsfaser 40 mit einer Länge von einigen Metern bis einigen Kilometern aufweist. Die Superkontinuumsfaser 40 weist ein Dispersionsminimum im Bereich der Mittenfrequenz des Halbleiterlasers 26 auf. Mittels des Superkontinuumsgenerators 38 sind aufgrund nichtlinearer Effekte wie Selbstphasenmodulation, Kreuzphasenmodulation und Vierwellenmischung, die bei einer hohen Lichtenergiedichte in einem Lichtleiter auftreten, das Spektrum des in dem Laserlichtleiters 37 geführten Ausgangslichtes des Halbleiterlasers 26 um einen Faktor von beispielsweise etwa 100 Gigahertz auf wenigstens etwa 25 Terahertz verbreiterbar. Das Ausgangslicht des Superkontinuumgenerators 38 ist in dem Kammlichtleiter 2 geführt.

Fig. 3 zeigt eine zweckmäßige Ausgestaltung des Mittenfrequenzreglers 6 des optischen Frequenzgenerators gemäß Fig. 1. Das in dem ersten Teilkammlichtleiter 4 geführte Ausgangslicht des Kammgenerators 1 ist mit dem in dem Referenzlichtleiter 7 geführten Ausgangslicht der Referenzlichtquelle 8 mittels eines Regelungslichtüberlagerers 41 beispielsweise in Gestalt in einer 3dB-X-Weiche überlagerbar und in gleichen Anteilen auf einen ersten Regelungslichtleiter 42 und einen zweiten Regelungslichtleiter 43 aufteilbar. Das Ausgangslicht der Regelungslichtleiter 42, 43 beaufschlagt jeweils eine von zwei in Reihe sowie in Sperrrichtung geschalteten Fotodioden als Mischelemente eines lichtempfindlichen Regelungsdetektors 44, dessen Bandbreite beispielsweise einige 10 Gigahertz beträgt. Das zwischen den beiden Fotodioden abgegriffene Ausgangssignal des Regelungsdetektors 44 ist über einen Regelungsvorverstärker 45 einem als Tiefpaß ausgestalteten Regelungszwischenfrequenzfilter 46 eingespeist, dessen obere Grenzfrequenz größer als die Sendefrequenz des Mikrowellensenders 13 ist.

Das Ausgangssignal des Regelungszwischenfrequenzfilters 46 ist einem ersten Eingang einer Komparatorschaltung 47 einspeisbar. An dem zweiten Eingang der Komparatorschaltung 47 liegt das Ausgangssignal eines Differenzfrequenzgenerators 48 an, der über die an die Steuereinheit 10 angeschlossene Differenzsteuerleitung 9 in seiner Sendefrequenz zwischen einem Minimalwert und einem Maximalwert einstellbar ist, wobei der Abstand zwischen dem Minimalwert und dem Maximalwert größer als die Sendefrequenz des Mikrowellensenders 13 ist. Mittels der Komparatorschaltung 47 ist die Differenz zwischen dem Ausgangssignal des Regelungszwischenfrequenzfilters 46 und der Sendefrequenz des Differenzfrequenzgenerators 48 bestimmbar und das über die Regelleitung 11 dem Kammgenerator 1 einspeisbares Regelsignal erzeugbar, mit dem bei einer Abweichung das Ausgangssignal des Regelungszwischenfrequenzfilters 46 von der Sendefrequenz des Differenzfrequenzgenerators 48 die Mittenfrequenz des Halbleiterlasers 26 nachregelbar ist. Durch Auswertung beispielsweise der Phase in der Komparatorschaltung 47 ist sichergestellt, daß die durch Mischung mit der Referenzfrequenz die Zwischenfrequenz erzeugende Kammlinie in der Frequenz höher als die Referenzfrequenz liegt.

Das mit dem Kammgenerator 1 des optischen Frequenzgenerators gemäß Fig. 1 erzeugbare Ausgangslicht weist somit um eine Mittenfrequenz über einen Spektralbereich von insgesamt etwa 25 Terahertz ein kammartiges Linienspektrum auf, wobei der Abstand zwischen benachbarten Seitenbändern der Sendefrequenz des Mikrowellensenders 13 entspricht. Durch Verändern der Sendefrequenz des Mikrowellensenders 13 ist bei konstanter Mittenfrequenz die Breite des Frequenzkammes, die sich aus der Anzahl der Spektrallinien multipliziert mit der Sendefrequenz ergibt, einstellbar. über die durch die Differenzsteuerleitung 9 sowie den Differenzfrequenzgenerator 48 einstellbare, der Komparatorschaltung 47 zugeführten Differenzfrequenz zwischen einer Spektrallinie in dem Ausgangslicht des Kammgenerators 1 sowie einer definierten, stabilen und schmalbandigen Spektrallinie in dem Ausgangslicht der Referenzlichtquelle 8 ist die Lage aller Spektrallinien des Frequenzkammes gleichsinnig über die dadurch induzierte Änderung der Mittenfrequenz verschiebbar.

Fig. 4 zeigt eine zweckmäßige Ausgestaltung eines Überlagerungsempfängers 17, in den entsprechend der Darstellung in Fig. 1 in dem Eingangslichtleiter 16 Prüflicht unbekannter Frequenz und in dem zweiten Teilkammlichtleiter 5 Ausgangslicht des Kammgenerators 1 eingespeist ist. Das in dem Eingangslichtleiter 16 geführte Prüflicht ist einem ersten Modenteiler 49 eingespeist, mit dem mittels einer Modentrennung beispielsweise die transversal-elektrische (TE-) Mode in einen ersten Prüflichtmodenleiter 50 und die transversalmagnetische (TM-) Mode in einen zweiten Prüflichtmodenleiter 51 aufteilbar sind.

Das in dem zweiten Teilkammlichtleiter 5 geführte Ausgangslicht des Kammgenerators 1 ist einem zweiten Modenteiler 52 zugeführt, mit dem die TE-Mode sowie die TM-Mode getrennt in einen ersten Kammlichtmodenleiter 53 sowie einen zweiten Kammlichtmodenleiter 54 aufteilbar sind. Die jeweils eine gleiche Mode führenden Modenleiter 50, 53 sind an einen ersten Schwebungsüberlagerer 55 angeschlossen. Die die andere Mode führenden Modenleiter 51, 54 sind mit einem zweiten Schwebungsüberlagerer 56 verbunden. Mit den Schwebungsüberlagerern 55, 56 in Gestalt von 3dB-X-Weichen sind die zugehörigen Moden aus dem zweiten Teilkammlichtleiter 5 und dem Eingangslichtleiter 16 überlagerbar und zu gleichen Teilen auf einen ersten Schwebungsüberlagerer 55 angeschlossene Schwebungslichtleiter 57, 58 und an den zweiten Schwebungsüberlagerer 56 angeschlossene Schwebungslichtleiter 59, 60 aufteilbar.

Das Ausgangslicht der an den ersten Schwebungsüberlagerer 55 angeschlossenen Schwebungslichtleiter 57, 58 beaufschlagt einen lichtempfindlichen ersten Schwebungslichtdetektor 61, der beispielsweise aus zwei in Sperrichtung in Reihe geschalteten Fotodioden besteht. Das beispielsweise zwischen den Fotodioden abgreifbare Ausgangssignal des ersten Schwebungslichtdetektors 61 ist über einen ersten Schwebungsvorverstärker 62 einem ersten Schwebungszwischenfrequenzfilter 63 einspeisbar. Das erste Schwebungszwischenfrequenzfilter 63 ist beispielsweise als Tiefpaß ausgebildet, dessen obere Grenzfrequenz kleiner als die Hälfte der Sendefrequenz des Mikrowellensenders 13 ist. Das Ausgangssignal des ersten Schwebungszwischenfrequenzfilters 63 liegt zum einen an einem ersten Schaltkontakt 64 eines Wechselschalters 65 an und ist zum anderen einem ersten Leistungsmesser 66 einspeisbar. Mit dem ersten Leistungsmesser 66 ist die Amplitude des Ausgangssignales des ersten Schwebungszwischenfrequenzfilters 63 bestimmbar und über die erste Leistungsleitung 18 der Steuerelektronik 10 einspeisbar.

Das Ausgangslicht der an den zweiten Schwebungsüberlagerer 56 angeschlossenen Schwebungslichtleiter 59, 60 beaufschlagt entsprechend einen lichtempfindlichen zweiten Schwebungslichtdetektor 67, dessen Ausgangssignal über einen zweiten Schwebungsvorverstärker 68 einem zweiten Schwebungszwischenfrequenzfilter 69 einspeisbar ist. Das Ausgangssignal des zweiten Schwebungszwischenfrequenzfilters 69 liegt zum einen an einem zweiten Schaltkontakt 70 des Wechselschalters 65 an und ist zum anderen einem zweiten Leistungsmesser 71 zum Messen der Amplitude des Ausgangssignales des zweiten Schwebungszwischenfrequenzfilters 69 eingespeist. Das Ausgangssignal des zweiten Leistungsmessers 71 ist über die zweite Leistungsleitung 19 der Steuerelektronik 10 einspeisbar.

Die Steuerelektronik 10 verfügt über ein Komparatorglied, dem über die Leistungsleitungen 18, 19 die Ausgangssignale der Leistungsmesser 66, 71 einspeisbar sind und mit dessen Ausgangssignal über die Schaltleitung 20 der Wechselschalter 65 in einen Schaltzustand überführbar ist, bei dem die Schwebungssignalleitung 21 mit dem intensiveren der Ausgangssignale der Schwebungszwischenfrequenzfilter 63, 69 verbunden ist.

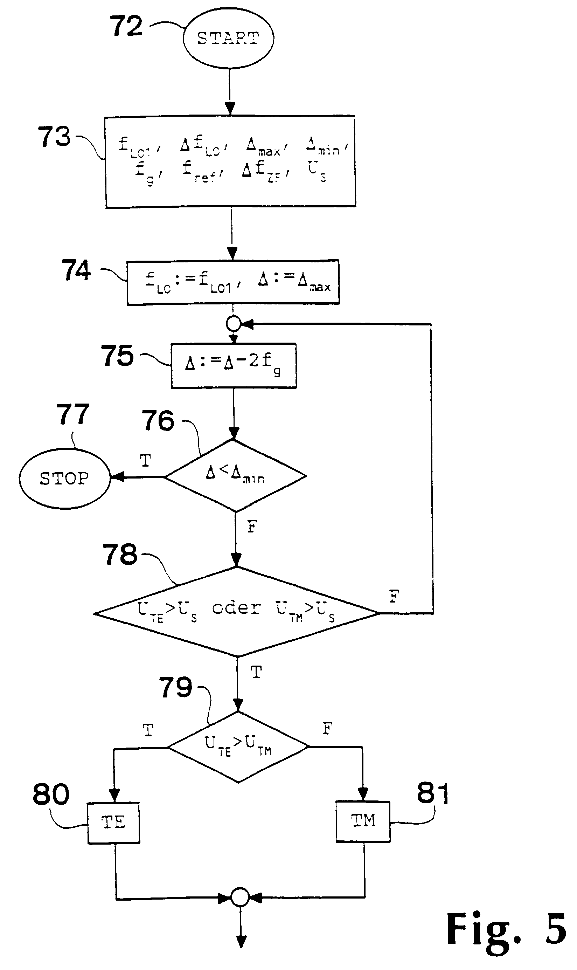

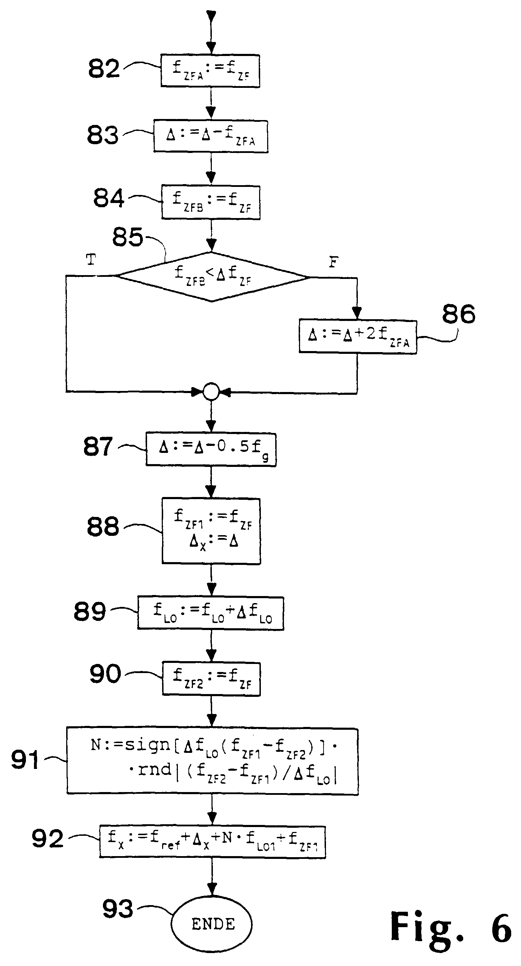

Fig. 5 und Fig. 6 zeigen einen zweckmäßigen Ablaufalgorithmus zum Durchführen einer Frequenzmessung mit dem optischen Frequenzgenerator gemäß Fig. 1. Die Abarbeitung des Ablaufalgorithmus erfolgt in der Steuerelektronik 10 entsprechend einem Steuerprogramm oder einer festverdrahteten Logik- und Speicherschaltung.

Gemäß Fig. 5 sind nach Auslösen eines Startsignales in einem Startschritt 72 in einem Speicherschritt 73 die zum Durchführen der Messung und Bestimmen der unbekannten Prüflichtfrequenz $f_X$ des Prüflichtes erforderlichen Größen in der Steuerelektronik 10 abspeicherbar. Zu diesen Größen zählen die Startfrequenz $f_{LO1}$ des Mikrowellensenders 13, die Seitenbandänderungsfrequenz $\Delta f_{LO}$ des Frequenzkammes des Kammgenerators 1, die maximale Verschiebefrequenz $\Delta_{max}$ als Sendefrequenz des Differenzfrequenzgenerators 48 in bezug auf die bekannte Referenzfrequenz $f_{ref}$ der Referenzlichtquelle 8, die minimale Verschiebefrequenz $\Delta_{min}$ als Sendefrequenz des Differenzfrequenzgenerators 48 in bezug auf die Referenzfrequenz $f_{ref}$, die Grenzfrequenz $f_g$ der Schwebungszwischenfrequenzfilter 63, 69 des Überlagerungsempfängers 17 gemäß Fig. 4, die Zentriertoleranzfrequenz $\Delta f_{ZF}$ bei dem Abgleich eines Seitenbandes des optischen Frequenzgenerators auf die zu bestimmende Prüflichtfrequenz $f_X$ und ein Minimalpegel $U_S$ als unteren Schwellwert zum Durchführen der Frequenzmessung.

Nach Eingabe der oben genannten Größen sind in einem Initialisierungsschritt 74 die Sendefrequenz $f_{LO}$ des Mikrowellensenders 13 auf die Startfrequenz $f_{LO1}$ mittels der Mikrowellensteuerleitung 14 sowie die Verschiebefrequenz $\Delta$ zwischen der Referenzfrequenz $f_{ref}$ und einer Frequenzkomponente des Ausgangslichtes des Kammgenerators 1 auf die maximale Verschiebefrequenz $\Delta_{max}$ mittels der Differenzsteuerleitung 9 einstellbar. Anschließend ist in einem Frequenzerniedrigungsschritt 75 die Verschiebefrequenz $\Delta$ um den doppelten Wert der Grenzfrequenz $f_g$ erniedrigt. In einem sich anschließenden Verschiebefrequenzprüfschritt 76 ist geprüft, ob die Verschiebefrequenz $\Delta$ kleiner als die minimale Verschiebefrequenz $\Delta_{min}$ ist. Bei Zutreffen dieser Bedingung ist die Messung in einem Stopschritt 77 abgebrochen.

Ist die Prüfbedingung des Verschiebefrequenzprüfschrittes 76 nicht erfüllt, ist in einem Signalprüfschritt 78 abgefragt, ob wenigstens entweder der transversal-elektrische (TE-) Signalpegel $U_{TE}$ beispielsweise des ersten Leistungsmessers 66 oder der transversal-magnetische (TM-) Signalpegel $U_{TM}$ des zweiten Leistungsmessers 71, die über die Leistungsleitungen 18, 19 der Steuerelektronik 10 zuführbar sind, größer als der Minimalpegel $U_S$ ist.

Liegt weder der TE-Signalpegel $U_{TE}$ noch der TM-Signalpegel $U_{TM}$ über dem Minimalpegel $U_S$, wird die Messung mit dem Frequenzerniedrigungsschritt 75 fortgeführt.

Ist wenigstens einer der Signalpegel $U_{TE}$, $U_{TM}$ größer als der Minimalpegel $U_S$, ist in einem Signalpegelvergleichsschritt 79 abgefragt, ob der TE-Signalpegel $U_{TE}$ größer als der TM-Signalpegel $U_{TM}$ ist. Bei Zutreffen ist mittels des Wechselschalters 65 in einem TE-Schaltschritt 80 durch Schließen des ersten Schaltkontaktes 64 das Ausgangssignal des ersten Schwebungszwischenfrequenzfilters 63 in die Schwebungssignalleitung 21 einspeisbar. Trifft hingegen die Prüfbedingung in dem Signalpegelvergleichsschritt 79 nicht zu, ist in einem TM-Schaltschritt 81 durch Schließen des zweiten Schaltkontaktes 70 das Ausgangssignal des zweiten Schwebungszwischenfrequenzfilters 69 in die Schwebungssignalleitung 21 einspeisbar.

Anschließend ist gemäß Fig. 6 in einem ersten Zwischenfrequenzprüfschritt 82 die mittels des Frequenzzählers 22 bestimmte Zwischenfrequenz $f_{ZF}$ als erster Zwischenfrequenzprüfwert $f_{ZFA}$ abspeicherbar. Anschließend ist in einem Verschiebefrequenzreduzierschritt 83 die Verschiebefrequenz $\Delta$ um den ersten Zwischenfrequenzprüfwert $f_{ZFA}$ erniedrigt und in einem zweiten Zwischenfrequenzprüfschritt 84 die mit dem Frequenzzähler 22 bestimmte Zwischenfrequenz $f_{ZF}$ als zweiter Zwischenfrequenzprüfwert $f_{ZFB}$ abspeicherbar.

Bei den Zwischenfrequenzprüfschritten 82, 84 ist eine Genauigkeit von etwa einem Zehntel der Grenzfrequenz $f_g$ der Schwebungszwischenfrequenzfilter 63, 69 ausreichend, so daß eine sehr schnelle Bestimmung der Zwischenfrequenzprüfwerte $f_{ZFA}$, $f_{ZFB}$ durchführbar ist.

Nach dem zweiten Zwischenfrequenzprüfschritt 84 ist in einem Zwischenfrequenzvergleichsschritt 85 überprüft, ob der zweite Zwischenfrequenzprüfwert $f_{ZFB}$ kleiner ist als die Zentriertoleranzfrequenz $\Delta f_{ZF}$. Bei Nichterfüllen dieser Bedingung ist in einem Verschiebefrequenzerhöhungsschritt 86 die Verschiebefrequenz $\Delta$ über die Differenzsteuerleitung 9 um das Doppelte des ersten Zwischenfrequenzprüfwertes $f_{ZFA}$ erhöhbar. Durch den bei Nichtzutreffen der Bedingung des Zwischenfrequenzvergleichsschrittes 85 durchgeführten Verschiebefrequenzerhöhungsschritt 86 ist sichergestellt, daß die die Zwischenfrequenz $f_{ZF}$ erzeugende Seitenbandfrequenz $f_N$ ungefähr gleich der unbekannten Prüflichtfrequenz $f_X$ ist.

Anschließend ist in einem Verschiebefrequenzverminderungsschritt 87 die Verschiebefrequenz $\Delta$ um die Hälfte der Grenzfrequenz $f_g$ der Schwebungszwischenfrequenzfilter 63, 69 verringert, so daß die Seitenbandfrequenz $f_N$ auf jeden Fall kleiner als die Prüflichtfrequenz $f_X$ ist. Es folgt in einem Zwischenfrequenzmeßschritt 88 die sehr genaue Messung der Zwischenfrequenz $f_{ZF}$ als erster Zwischenfrequenzmeßwert $f_{ZF1}$ und ein Abspeichern der Verschiebefrequenz $\Delta$ als Kammlichtverschiebefrequenzwert $\Delta_X$. Der Zwischenfrequenzmeßschritt 88 ist mit einer der zu erreichenden Meßgenauigkeit der Prüflichtfrequenz $f_X$ entsprechenden Dauer durchgeführt.

Nach dem ersten Zwischenfrequenzmeßschritt 88 ist die Sendefrequenz $f_{LO}$ des Mikrowellensenders 13 um die Seitenbandän-

derungsfrequenz $\Delta f_{LO}$ multipliziert mit der halben Gesamtzahl der Seitenbänder in einem Sendefrequenzänderungsschritt 89 verstellbar, wobei die Seitenbandänderungsfrequenz $\Delta f_{LO}$ multipliziert mit der halben Gesamtzahl der Seitenbänder im Betrag kleiner als der erste Zwischenfrequenzmeßwert $f_{ZF1}$ ist. In einem sich anschließenden Zwischenfrequenzbestimmungsschritt 90 ist die Zwischenfrequenz $f_{ZF}$ als zweiter Zwischenfrequenzmeßwert $f_{ZF2}$ mit einer Genauigkeit von etwa einem Zehntel der Seitenbandänderungsfrequenz $\Delta f_{LO}$ bestimmbar und abgespeichert.

Die Messung von Frequenzwerten ist nunmehr abgeschlossen. Mit den abgespeicherten Zwischenfrequenzmeßwerten $f_{ZF1}$, $f_{ZF2}$ sowie der Seitenbandänderungsfrequenz $\Delta f_{LO}$ ist nunmehr die Seitenbandzahl N in Betrag und Vorzeichen in einem Seitenbandbestimmungsschritt 91 gemäß der nachfolgenden Gleichung bestimmbar:

$$N := sign[\Delta f_{LO}(f_{ZF1} - f_{ZF2})] \cdot rnd \left| (f_{ZF2} - f_{ZF1})/\Delta f_{LO} \right|,$$

wobei "sign" eine Vorzeichenbestimmungsfunktion und "rnd" eine ganzzahlige Rundungsfunktion bezeichnen.

Mit der bekannten Referenzfrequenz $f_{ref}$, dem Kammlichtverschiebungsfrequenzwert $\Delta_X$, der in dem Seitenbandbestimmungsschritt 91 berechneten Seitenbandzahl N, der Startfrequenz $f_{LO1}$ des Mikrowellensenders 13 sowie dem ersten Zwischenfrequenzmeßwert $f_{ZF1}$ ist nunmehr in einem Prüflichtfrequenzberechnungsschritt 92 entsprechend dem nachfolgenden Ausdruck die unbekannte Prüflichtfrequenz $f_X$ absolut bestimmbar:

$$f_X := f_{ref} + \Delta_X + N \cdot f_{LO1} + f_{ZF1}.$$

Nach Ausgabe der Prüflichtfrequenz $f_X$ in der Frequenzanzeigevorrichtung 25 ist die Messung in einem Abschlußschritt 93 beendet. Die Prüflichtfrequenz $f_X$ ist somit allein bei Kenntnis der Referenzfrequenz $f_{ref}$, des Kammlichtverschiebungsfrequenzwertes $\Delta_X$, der Mikrowellensenderfrequenz $f_{LO1}$, der bekannten Seitenbandänderungsfrequenz $\Delta f_{LO}$ sowie zwei gemessenen Zwischenfrequenzmeßwerten $f_{ZF1}$, $f_{ZF2}$ im Bereich von Radiofrequenzen oder Mikrowellen bestimmbar, ohne daß es vieler Regelkreise für eine Kette von optischen parametrischen Oszillatoren oder der direkten Messung einer Lichtfrequenz beziehungsweise Wellenlänge bedarf. Die Genauigkeit der Bestimmung der Prüflichtfrequenz $f_X$ ist im wesentlichen durch die Stabilität der Referenzlichtquelle 8 in bezug auf die Referenzfrequenz $f_{ref}$ gegeben und liegt typischerweise im Bereich von wenigen 100 Kilohertz.

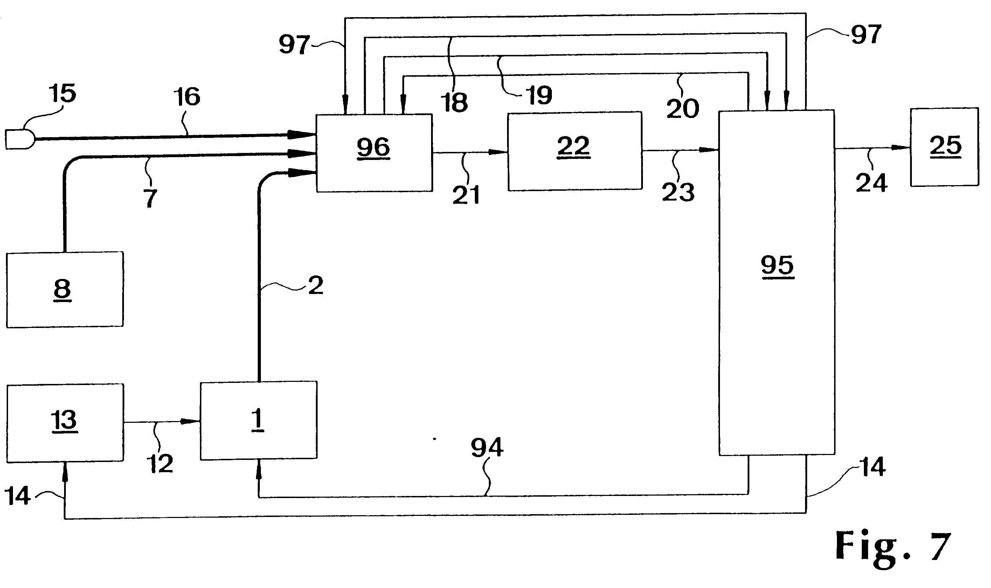

Fig. 7 zeigt in einem Blockschaltbild ein weiteres Ausführungsbeispiel eines optischen Frequenzgenerators in der Verwendung zum Messen von unbekannten Lichtfrequenzen. Sich entsprechende Bauelemente der in Fig. 1 und Fig. 7 dargestellten optischen Frequenzgeneratoren sind mit gleichen Bezugszeichen versehen und im einzelnen nachstehend nicht näher erläutert.

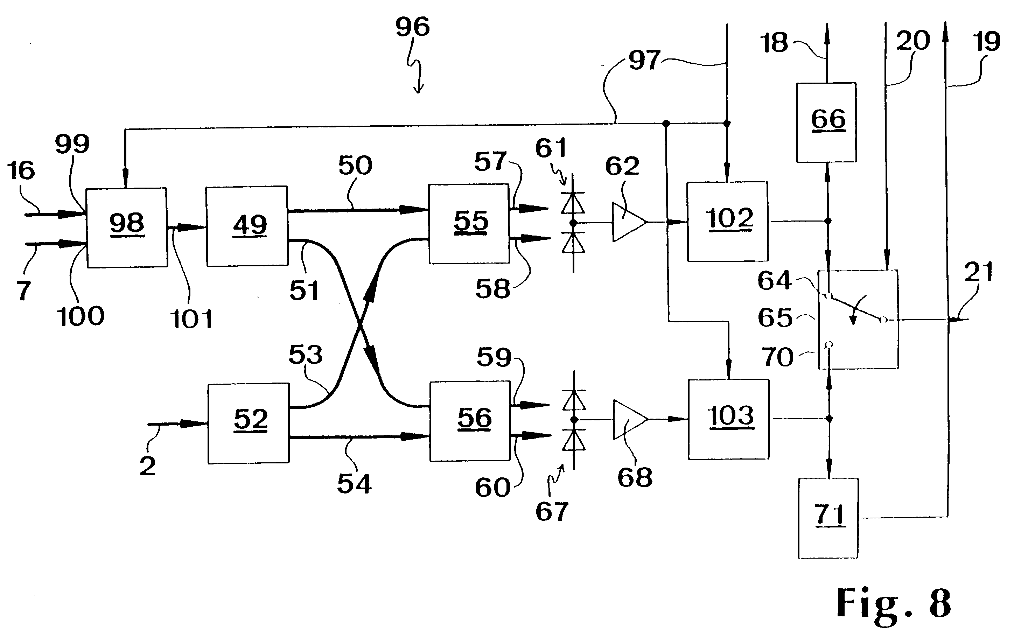

Der Kammgenerator 1 des optischen Frequenzgenerators gemäß Fig. 7 ist über eine Regelleitung 94 unmittelbar an eine Doppelsteuerelektronik 95 angeschlossen, mit der die Mittenfrequenz des Kammgenerators 1 direkt einstellbar ist. Das in dem Kammlichtleiter 2 geführte Ausgangslicht des Kammgenerators 1, das in dem Referenzlichtleiter 7 geführte Ausgangslicht der Referenzlichtquelle 8 sowie das in dem Eingangslichtleiter 16 über den Eingangskoppler 15 geführte Prüflicht unbekannter Frequenz ist einem unter Bezug auf Fig. 8 näher erläuterten Doppelüberlagerungsempfänger 96 als Überlagerungseinheit zugeführt. Der Doppelüberlagerungsempfänger 96 ist über eine an die Doppelsteuerelektronik 95 angeschlossene Lichtwahlschaltleitung 97 mit einem Schaltsignal beaufschlagbar, mit dem zwischen einem Referenzschwebungssignal bei Überlagerung des Ausgangslichtes des Kammgenerators 1 und des Ausgangslichtes der Referenzlichtquelle 8 oder einem Prüfschwebungssignal bei Überlagerung des Ausgangslichtes des Kammgenerators 1 und des Prüflichtes umschaltbar ist.

Fig. 8 zeigt in einem Blockschaltbild den Doppelüberlagerungsempfänger 96 gemäß Fig. 7, wobei sich in Fig. 4 und Fig. 8 entsprechende Bauelemente mit gleichen Bezugszeichen versehen und im einzelnen nicht näher erläutert sind. Der Doppelüberlagerungsempfänger 96 verfügt über einen Eingangslichtwahlschalter 98, an dessen ersten Eingang 99 der Eingangslichtleiter 16 und an dessen zweiten Eingang 100 der Referenzlichtleiter 7 angeschlossen sind. Mittels eines Schaltsignales in der an den Eingangslichtwahlschalter 99 angeschlossenen Lichtwahlschaltleitung 97 ist über einen Lichtwahllichtleiter 101 entweder das in dem Eingangslichtleiter 16 geführte Prüflicht oder das in dem Referenzlichtleiter 7 geführte Ausgangslicht der Referenzlichtquelle 8 dem ersten Modenteiler 49 einspeisbar. Dem zweiten Modenteiler 52 ist das in dem Kammlichtleiter 2 geführte Ausgangslicht des Kammgenerators 1 zugeführt.

Die entsprechend dem Überlagerungsempfänger 17 gemäß Fig. 4 erzeugten Ausgangssignale der Schwebungslichtdetektoren 61, 67 sind über Schwebungsvorverstärker 62, 68 einem ersten Doppelschwebungszwischenfrequenzfilter 102 und einem zweiten Doppelschwebungszwischenfrequenzfilter 103 eingespeist. Das Ausgangssignal des ersten Doppelschwebungszwischenfrequenzfilter 102 ist einerseits dem ersten Leistungsmesser 66 zugeführt und liegt andererseits an dem ersten Schaltkontakt 64 des Wechselschalters 65 an. Das Ausgangssignal des zweiten Doppelschwebungszwischenfrequenzfilters 103 ist entsprechend dem zweiten Leistungsmesser 71 eingespeist und liegt an dem zweiten Schaltkontakt 70 des Wechselschalters 65 an. Die Doppelschwebungszwischenfrequenzfilter 102, 103 sind mit dem Schaltsignal der Lichtwahlschaltleitung 97 beaufschlagbar.

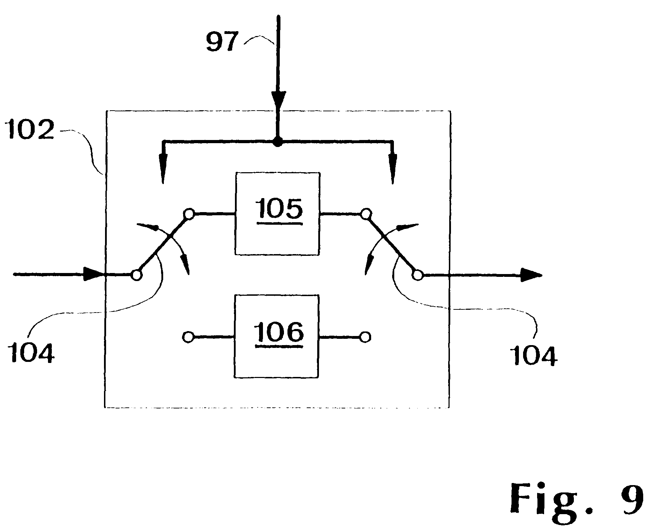

Fig. 9 zeigt in einem Blockschaltbild den Aufbau des ersten Doppelschwebungszwischenfrequenzfilters 102. Das zweite Doppelschwebungszwischenfrequenzfilter 103 ist entsprechend ausgeführt. Mit dem in der Lichtwahlschaltleitung 97 geführten Schaltsignal ist ein Filterwahlschalter 104 betätigbar, mit dem entweder ein Prüflichtzwischenfrequenzfilter 105 oder ein Referenzlichtzwischenfrequenzfilter 106 als aktives Filter zuschaltbar sind. Zweckmäßigerweise sind die Zwischenfrequenzfilter 105, 106 als Tiefpässe ausgeführt, wobei die Grenzfrequenz des Prüflichtzwischenfrequenzfilters 105 kleiner ist als die Grenzfrequenz des Referenzlichtzwischenfrequenzfilters 106.

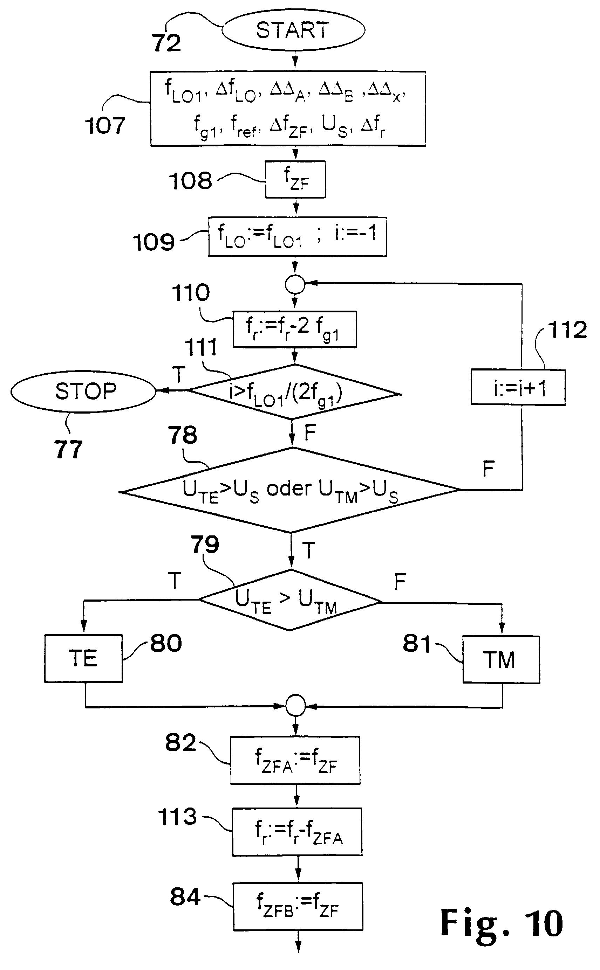

Fig. 10, Fig. 11 und Fig. 12 zeigen einen gegenüber dem Ablaufalgorithmus gemäß Fig. 5 und Fig. 6 modifizierten Ablaufalgorithmus zum Durchführen einer Frequenzmessung mit dem optischen Frequenzgenerator gemäß Fig. 7. Die Abarbeitung des Ablaufalgorithmus erfolgt in der Doppelsteuerelektronik 95 entsprechend einem Steuerprogramm oder einer festverdrahteten Logik- und Speicherschaltung, wobei sich in den Fig. 5 und Fig. 6 sowie den Fig. 10, Fig. 11 und Fig. 12 entsprechende Schritte mit den gleichen Bezugszeichen versehen sind.

Gemäß Fig. 10 sind nach Auslösen eines Startsignales in dem Startschritt 72 in einem Speicherschritt 107 die zum Durchführen der Messung und Bestimmen der unbekannten Prüflichtfrequenz $f_X$ des Prüflichtes erforderlichen Größen in der Doppelsteuerelektronik 95 abspeicherbar. Neben der Startfrequenz $f_{LO1}$ des Mikrowellensenders 13, der Seitenbandänderungsfrequenz $\Delta f_{LO}$ des Frequenzkammes des Kammgenerators 1, der Referenzfrequenz $f_{ref}$ der Referenzlichtquelle 8, der Zentriertoleranzfrequenz $\Delta f_{ZF}$ sowie dem Minimalpegel $U_S$ sind ein Verschiebefrequenzgrenzwert $\Delta\Delta_A$, ein Verschiebefrequenztoleranzwert $\Delta\Delta_B$, ein Kammlichttoleranzwert $\Delta\Delta_X$ sowie ein Kammlichtsprungwert $\Delta f_r$ abgespeichert. Als weitere Größe ist ein Prüflichtzwischenfrequenzgrenzwert $f_{g1}$ abgespeichert, der der Grenzfrequenz der Prüflichtzwischenfrequenzfilter 105 entspricht.

In einem sich anschließenden Schalterstellschritt 108 sind die Prüflichtzwischenfrequenzfilter 105 der Doppelschwebungszwischenfrequenzfilter 102, 103 zugeschaltet und der Eingangslichtwahlschalter 98 zum Überlagern des Prüflichtes mit dem Ausgangslicht des Kammgenerators 1 geschaltet. In einem nachfolgenden Initialisierungsschritt 109 ist die Sendefrequenz $f_{LO}$ des Mikrowellensenders 13 auf die Startfrequenz $f_{LO1}$ eingestellt und in einem Schrittzähler i der Wert minus eins abgespeichert.

In einem sich anschließenden Kammlichtfrequenzerniedrigungsschritt 110 ist die Mittenfrequenz $f_r$ des Kammlichtgenerators 1 um den doppelten Wert des Prüflichtzwischenfrequenzgrenzwertes $f_{g1}$ erniedrigt. In einem nachfolgenden Schrittzählerprüfschritt 111 ist abgefragt, ob der Wert des Schrittzählers i größer ist als die Startfrequenz $f_{LO1}$ des Mikrowellensenders 13 dividiert durch den doppelten Wert des Prüflichtzwischenfrequenzgrenzwertes $f_{g1}$. Trifft diese Bedingung zu, ist die Messung in dem Stopschritt 77 abgebrochen.

Ist die Prüfbedingung des Schrittzählerprüfschrittes 111 nicht erfüllt, ist in dem nachfolgenden Signalprüfschritt 78 abgefragt, ob wenigstens entweder der TE-Signalpegel $U_{TE}$ beispielsweise des ersten Leistungsmessers 66 oder der TM-Signalpegel $U_{TM}$ des zweiten Leistungsmessers 71 größer als der Minimalpegel $U_S$ ist.

übersteigt weder der TE-Signalpegel $U_{TE}$ noch der TM-Signalpegel $U_{TM}$ den Minimalpegel $U_S$, ist in einem Schrittzählererhöhungsschritt 112 der Schrittzähler i um den Wert eins erhöht und anschließend ein weiterer Kammlichtfrequenzerniedrigungsschritt 110 ausgeführt.

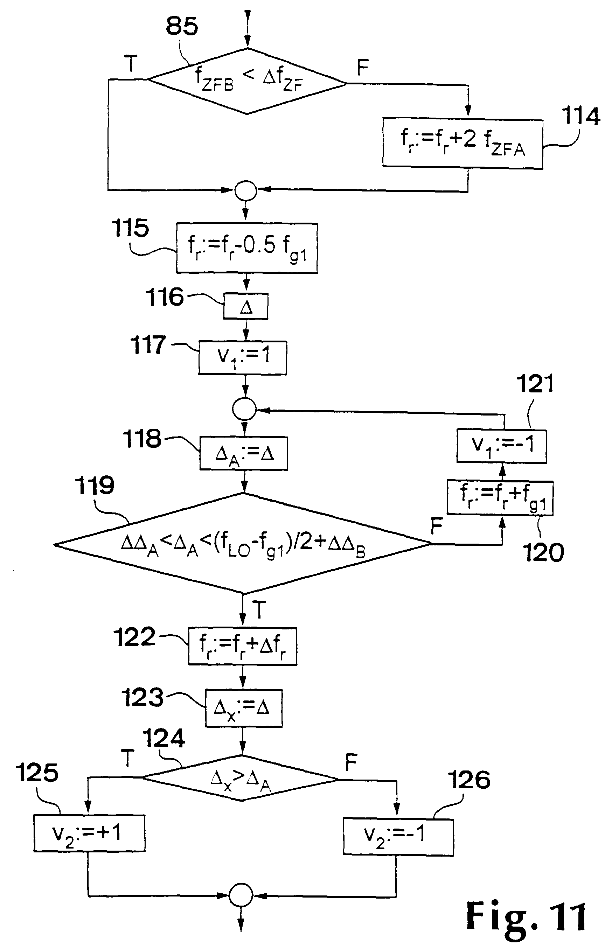

Ist wenigstens einer der Signalpegel $U_{TE}$, $U_{TM}$ größer als der Minimalpegel $U_S$, ist entsprechend dem Ablaufalgorithmus gemäß Fig. 5 und Fig. 6 durch Ausführen entweder des TE-Schaltschrittes 80 oder des TM-Schaltschrittes 81 in Abhängigkeit der relativen Größe der Signalpegel $U_{TE}$, $U_{TM}$ fortgefahren und in dem ersten Zwischenfrequenzprüfschritt 82 die Zwischenfrequenz $f_{ZF}$ als erster Zwischenfrequenzprüfwert $f_{ZFA}$ abgespeichert. Anschließend ist in einem Kammlichtfrequenzreduzierschritt 113 die Mittenfrequenz $f_r$ um den ersten Zwischenfrequenzprüfwert $f_{ZFA}$ erniedrigt. Dann ist in dem zweiten Zwischenfrequenzprüfschritt 84 die Zwischenfrequenz $f_{ZF}$ als zweiter Zwischenfrequenzprüfwert $f_{ZFB}$ abgespeichert sowie gemäß Fig. 11 in dem sich anschließenden Zwischenfrequenzvergleichschritt 85 überprüft, ob der zweite Zwischenfrequenzprüfwert $f_{ZFB}$ kleiner ist als die Zentriertoleranzfrequenz $\Delta f_{ZF}$.

Bei Nichtzutreffen dieser Bedingung ist in einem Kammlichtfrequenzerhöhungsschritt 114 die Mittenfrequenz $f_r$ um den doppelten Wert des ersten Zwischenfrequenzprüfwertes $f_{ZFA}$ erhöht. Dadurch ist sichergestellt, daß die die Zwischenfrequenz $f_{ZF}$ erzeugende Seitenbandfrequenz $f_N$ ungefähr gleich der unbekannten Prüflichtfrequenz $f_X$ ist.

Anschließend ist in einem Kammlichtfrequenzverminderungsschritt 115 die Mittenfrequenz $f_r$ um den halben Wert des Prüflichtzwischenfrequenzgrenzwertes $f_{g1}$ erniedrigt und in einem Schalterstellschritt 116 mittels eines Schaltsignales in der Lichtwahlschaltleitung 97 die Referenzlichtzwischenfrequenzfilter 106 der Doppelschwebungszwischenfrequenzfilter 102, 103 zugeschaltet sowie der Eingangslichtwahlschalter 98 zum Einleiten des Ausgangslichtes der Referenzlichtquelle 8 in den ersten Modenteiler 49 geschaltet. Anschließend ist in einem Zwischenfrequenzvorzeichensetzschritt 117 eine Zwischenfrequenzvorzeichenvariable $v_1$ auf den Wert plus eins gesetzt.

In einem nachfolgenden Verschiebefrequenzbestimmungsschritt 118 ist die Verschiebefrequenz $\Delta$

zwischen der Referenzfrequenz $f_{ref}$ und einer Frequenzkomponente des Ausgangslichtes des Kammgenerators 1 als Verschiebefrequenzprüfwert $\Delta_A$ abspeicherbar. In einem sich anschließenden Bereichsprüfschritt 119 ist überprüft, ob der Verschiebefrequenzprüfwert $\Delta_A$ zwischen dem Verschiebefrequenzgrenzwert $\Delta\Delta_A$ und der Summe aus der Hälfte der Differenz zwischen der Sendefrequenz $f_{LO}$ des Mikrowellensenders 13 sowie dem Prüflichtzwischenfrequenzgrenzwert $f_{g1}$ und dem Verschiebefrequenztoleranzwert $\Delta\Delta_B$ liegt.

Liegt der Verschiebefrequenzprüfwert $\Delta_A$ nicht innerhalb dieses Bereiches, ist in einem Kammlichtfrequenzsteigerungsschritt 120 die Mittenfrequenz $f_r$ um den Prüflichtzwischenfrequenzgrenzwert $f_{g1}$ erhöht sowie in einem Zwischenfrequenzvorzeichensetzschritt 121 die Zwischenfrequenzvorzeichenvariable $v_1$ auf den Wert minus eins gesetzt. Danach ist mit einem weiteren Verschiebefrequenzbestimmungsschritt 118 fortgefahren.

Liegt der Verschiebefrequenzprüfwert $\Delta_A$ in dem in dem Bereichsprüfschritt 119 überprüften Bereich, ist die Mittenfrequenz $f_r$ in einem Kammlichtfrequenzsprungschritt 122 um den Kammlichtsprungwert $\Delta f_r$ verändert und in einem sich anschließenden Verschiebefrequenzmeßschritt 123 die Verschiebefrequenz $\Delta$ als Verschiebefrequenzmeßwert $\Delta_X$ mit hoher Genauigkeit mit dem Frequenzzähler 22 gemessen.

Nach dem Verschiebefrequenzmeßschritt 123 ist in einem Verschiebefrequenzvergleichsschritt 124 überprüft, ob der Verschiebefrequenzmeßwert $\Delta_X$ größer ist als der Verschiebefrequenzprüfwert $\Delta_A$. Bei Zutreffen dieser Bedingung ist in einem Verschiebefrequenzvorzeichensetzschritt 125 einer Verschiebefrequenzvorzeichenvariable $v_2$ der Wert plus eins zugewiesen. Bei Nichtzutreffen der Prüfbedingung in dem Verschiebefrequenzvergleichsschritt 124 ist in einem anderen Verschiebefrequenzvorzeichensetzschritt 126 der Wert der Vergleichsfrequenzvorzeichenvariable $v_2$ auf minus eins gesetzt.

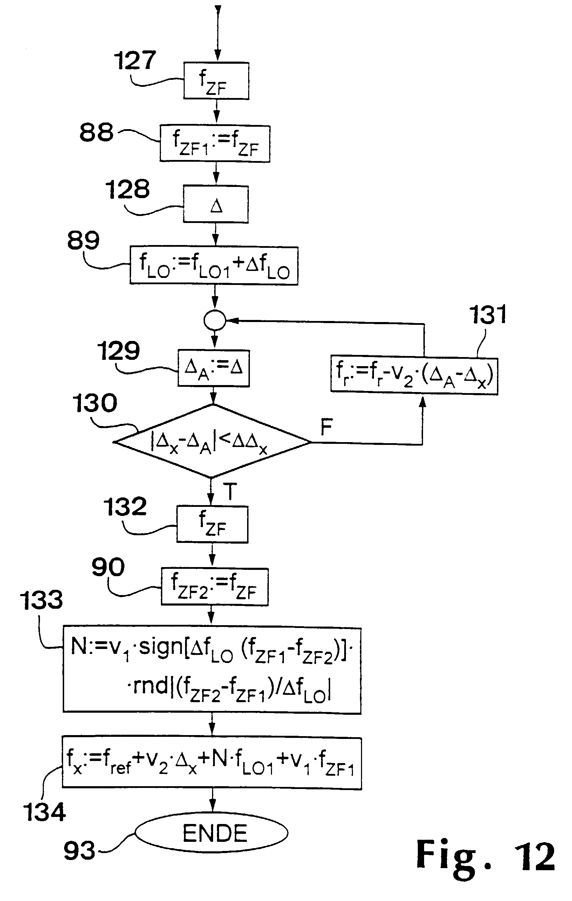

Anschließend sind gemäß Fig. 12 in einem Schalterstellschritt 127 mittels eines Schaltsignales in der Lichtwahlschaltleitung 97 zum einen das Prüflicht dem ersten Modenteiler 49 zugeführt und zum anderen die Prüflichtzwischenfrequenzfilter 105 zugeschaltet. Nun ist in dem Zwischenfrequenzmeßschritt 88 die sich aus der Überlagerung des Prüflichtes mit dem Ausgangslicht des Kammgenerators 1 ergebende Zwischenfrequenz $f_{ZF}$ mit hoher Genauigkeit gemessen und als erster Zwischenfrequenzmeßwert $f_{ZF1}$ abgespeichert. Dann sind in einem Schalterstellschritt 128 über ein Schaltsignal in der Lichtwahlschaltleitung 97 die Referenzlichtzwischenfrequenzfilter 106 zugeschaltet und dem ersten Modenteiler 49 das Ausgangslicht der Referenzlichtquelle 8 zugeführt. In dem sich anschließenden Sendefrequenzänderungsschritt 89 ist die Sendefrequenz $f_{LO}$ des Mikrowellensenders 13 von der Startfrequenz $f_{LO1}$ um die Seitenbandänderungsfrequenz $\Delta f_{LO}$ verändert.

Danach ist in einem weiteren Verschiebefrequenzbestimmungsschritt 129 die Verschiebefrequenz $\Delta$ gemessen und als Verschiebefrequenzprüfwert $\Delta_A$ abgespeichert. In einem nachfolgenden Toleranzprüfschritt 130 ist überprüft, ob die betragsmäßige Differenz zwischen dem Verschiebefrequenzmeßwert $\Delta_X$ und dem in dem weiteren Verschiebefrequenzbestimmungsschritt 129 gemessenen Verschiebefrequenzprüfwert $\Delta_A$ kleiner ist als der Kammlichttoleranzwert $\Delta\Delta_X$.

Bei Nichtzutreffen der Prüfbedingung in dem Toleranzprüfschritt 130 ist in einem Kammlichtfrequenzveränderungsschritt 131 die Mittenfrequenz $f_r$ des Ausgangslichtes des Kammgenerators 1 um die mit dem Wert der Verschiebefrequenzvorzeichenvariable $v_2$ multiplizierte Differenz zwischen dem Verschiebefrequenzprüfwert $\Delta_A$ und dem Verschiebefrequenzmeßwert $\Delta_X$ erniedrigt. Anschließend ist mit einem weiteren Verschiebefrequenzbestimmungsschritt 129 fortgefahren.

Trifft die Prüfbedingung in dem Toleranzprüfschritt 130 zu, sind in einem Schalterstellschritt 132 über ein Schaltsignal in der Lichtwahlschaltleitung 97 das Prüflicht in den ersten Modenteiler 49 einspeisbar und die Prüflichtzwischenfrequenzfilter 105 zuschaltbar. Anschließend ist in dem Zwischenfrequenzbestimmungsschritt 90 die bei Überlagerung des Prüflichtes mit dem Ausgangslicht des Kammgenerators 1 auftretende Zwischenfrequenz $f_{ZF}$ bestimmt und als zweiter Zwischenfrequenzmeßwert $f_{ZF2}$ erfaßt. Dann ist in einem Seitenbandbestimmungsschritt 133 die Seitenbandzahl N in Betrag und Vorzeichen mittels der aktuellen Zwischenfrequenzvorzeichenvariablen $v_1$, der Seitenbandänderungsfrequenz $\Delta f_{LO}$ sowie den abgespeicherten Zwischenfrequenzmeßwerten $f_{ZF1}$, $f_{ZF2}$ entsprechend der nachfolgenden Gleichung bestimmbar:

$$N := v_1 \cdot \text{sign}[\Delta f_{LO}(f_{ZF1} - f_{ZF2})] \cdot \text{rnd} \left| (f_{ZF2} - f_{ZF1}) / \Delta f_{LO} \right| ,$$

wobei "sign" eine Vorzeichenbestimmungsfunktion und "rnd" eine ganzzahlige Rundungsfunktion bezeichnen.

In einem Prüflichtfrequenzberechnungsschritt 134 ist nunmehr die unbekannte Prüflichtfrequenz $f_X$ als Summe der Referenzfrequenz $f_{ref}$ des mit der Verschiebefrequenzvorzeichenvariablen $v_2$ multiplizierten Verschiebefrequenzmeßwertes $\Delta_X$, der mit der Seitenbandzahl N multiplizierten Startfrequenz $f_{LO1}$ und des mit der Zwischenfrequenzvorzeichenvariablen $v_1$ multiplizierten ersten Zwischenfrequenzmeßwertes $f_{ZF1}$ entsprechend dem nachfolgenden Ausdruck absolut bestimmbar:

$$f_X := f_{ref} + v_2 \cdot \Delta_X + N \cdot f_{LO1} + v_1 \cdot f_{ZF1} .$$

Nach Ausgabe der Prüflichtfrequenz $f_X$ in der Frequenzanzeigevorrichtung 25 ist die Messung in dem Abschlußschritt 93 beendet.

Das letztgenannte Ausführungsbeispiel eignet sich insbesondere in Anwendungsfällen, bei denen der Mittenfrequenzregler 6 in der in Fig. 1 dargestellten Ausführung sehr breitbandig auszulegen ist und auch bei sehr hohen Frequenzen präzise zu regeln hat. Diese technisch nur sehr aufwendig zu realisierenden Erfordernisse sind bei dem letztgenannten Ausführungsbeispiel mittels Messungen von Verschiebefrequenzen Δ vermieden, die zwar zu einer etwas längeren Meßzeit führen, dafür allerdings den apparativen Aufbau des optischen Frequenzgenerators in der Verwendung zum Bestimmen unbekannter optischer Frequenzen vereinfachen.

## Patentansprüche

1. Optischer Frequenzgenerator mit einer Referenzlichtquelle, mit einem Frequenzsender (13), mit einem optischen Kammgenerator zum Erzeugen einer Vielzahl optischer Frequenzen und mit einer Steuerelektronik, **dadurch gekennzeichnet**, daß der Kammgenerator (1) eine mit einem mittels der Steuerelektronik (10, 95) in der Frequenz einstellbaren Ausgangssignal des Frequenzsenders (13) sowie mit einem Regelsignal frequenzmodulierbare Lichtquelle (26) und ein von Ausgangslicht der Lichtquelle (26) beaufschlagtes, optisches nichtlineares Bauelement (38) aufweist, wobei mit der Lichtquelle (26) und dem optisch nichtlinearen Bauelement (38) um eine durch das Regelsignal einstellbare Mittenfrequenz eine Vielzahl von Seitenbändern mit einem Vielfachen der Frequenz des eingespeisten Ausgangssignales des Frequenzsenders (13) entsprechenden Frequenzabständen erzeugbar sind, und daß Ausgangslicht des Kammgenerators (1) mit Ausgangslicht der Referenzlichtquelle (8) in einer Überlagerungseinheit (6, 96) zur Erzeugung des Regelsignales überlagerbar ist.

2. Optischer Frequenzgenerator nach Anspruch 1, dadurch gekennzeichnet, daß die Lichtquelle des Kammgenerators (1) ein modengekoppelter Halbleiterlaser (26) mit einem externen Resonator (28, 29) ist.

3. Optischer Frequenzgenerator nach Anspruch 2, dadurch gekennzeichnet, daß das Ausgangssignal des Frequenzsenders (13) mittels einer Lasersteuerschaltung (35) dem Steuerstrom des Halbleiterlasers (26) aufgeprägt ist.

4. Optischer Frequenzgenerator nach Anspruch 2 oder 3, dadurch gekennzeichnet, daß der Steuerstrom des Halbleiterlasers (26) einen zu dem Regelsignal korrelierten Anteil aufweist.

5. Optischer Frequenzgenerator nach einem der Ansprüche 2 bis 4, dadurch gekennzeichnet, daß der Resonator des Halbleiterlasers (26) ein Reflexionsgitter (29) zum Einstellen der Mittenfrequenz aufweist.

6. Optischer Frequenzgenerator nach einem der Ansprüche 1 bis 5, dadurch gekennzeichnet, daß das optisch nichtlineare Bauelement (38) des Kammgenerators (1) einen von dem Ausgangslicht der Lichtquelle (26) beaufschlagten Lichtverstärker (39) und eine von Ausgangslicht des Lichtverstärkers (39) beaufschlagte Lichtleitfaser (40) mit einem Dispersionsminimum um die Mittenfrequenz der Lichtquelle (26) aufweist.

7. Optischer Frequenzgenerator nach einem der Ansprüche 1 bis 6, dadurch gekennzeichnet, daß die Überlagerungseinheit (6, 96) über wenigstens einen von Ausgangslicht des Kammgenerators (1) und Ausgangslicht der Referenzlichtquelle (8) beaufschlagten lichtempfindlichen Detektor (44, 61, 67) sowie einen Frequenzfilter (46, 106) verfügt und eine Bandbreite aufweist, die höchstens der größten Frequenzdifferenz zwischen dem Ausgangslicht der Referenzlichtquelle (8) und dem Ausgangslicht des Kammgenerators (1) entspricht.

8. Optischer Frequenzgenerator nach Anspruch 7, dadurch gekennzeichnet, daß die Überlagerungseinheit (6) eine Komparatorschaltung (47) aufweist, deren Ausgangssignal zu der Abweichung einer von dem lichtempfindlichen Detektor (44) detektierten Schwebungsfrequenz und einer von einem von der Steuerschaltung (10) ansteuerbaren Differenzfrequenzgenerator (48) der Komparatorschaltung (47) zugeführten Differenzfrequenz als Regelsignal korreliert ist.

9. Optischer Frequenzgenerator nach Anspruch 7, dadurch gekennzeichnet, daß mit der Überlagerungseinheit (96) ein durch Überlagerung des Ausgangslichtes der Referenzlichtquelle (8) mit dem Ausgangslicht des Kammgenerators (1) auf dem lichtempfindlichen Detektor (61, 67) erzeugtes Schwebungsfrequenzsignal als Regelsignal einer Steuerelektronik (95) einspeisbar ist, mit der ein weiteres Regelsignal zur Ansteuerung der Lichtquelle (26) erzeugbar ist.

10. Optischer Frequenzgenerator nach einem der Ansprüche 1 bis 9, dadurch gekennzeichnet, daß das Ausgangslicht des optischen Frequenzgenerators mit Ausgangslicht unbekannter Frequenz einer Prüflichtquelle in einem Überlagerungsempfänger (17, 96) mit einer höchstens der Hälfte der kleinsten Sendefrequenz des Frequenzsenders (13) entsprechenden Bandbreite überlagerbar ist, dessen Ausgangssignal als Schwebungssignal zu einer Frequenzdifferenz zwischen dem Ausgangslicht des optischen Frequenzgenerators und dem Ausgangslicht der Prüflichtquelle korreliert ist.

11. Optischer Frequenzgenerator nach Anspruch 10, dadurch gekennzeichnet, daß das Ausgangssignal des Überlagerungsempfängers (17, 96) einem Frequenzzähler (22) einspeisbar ist, mit dem die Frequenz des Schwebungssignales bestimmbar und als Frequenzwert der Steuerelektronik (10, 95) einspeisbar ist.

12. Optischer Frequenzgenerator nach Anspruch 11, dadurch gekennzeichnet, daß mit der Steuerelektronik (10, 95) mittels der Frequenz des Ausgangslichtes der Referenzlichtquelle (8), der Sendefrequenz des Frequenzgebers (13) sowie einer Verschiebefrequenz als Differenz zwischen der Frequenz des Ausgangslichts der Referenzlichtquelle (8) und einer Frequenzkomponente des Ausgangslichtes des Kammgenerators (1) die Frequenz des Ausgangslichtes der Prüflichtquelle absolut bestimmbar ist.

## Claims

1. Optical frequency generator with a reference light source, with a frequency transmitter (13), with an optical comb generator for generating a plurality of optical frequencies and with an electronic control, characterized by the fact that
the comb generator (1) ist provided with a light source (26) the frequency of which may be modulated by the output signal of the frequency transmitter (13) by the electronic control (10, 95) and the frequency of which may be modulated by a control signal and with an optically non-linear component (38) energized by the light output of the light source (26), whereby a plurality of sidebands having a frequency spacing corresponding to a multiple of the frequency of the output signal received from the frequency transmitter (13) may be generated about a center frequency adjustable by the control signal light source 26 and the optically non-linear component (38), and that the light output of the comb generator (1) may be combined (superheterodyne) in a superheterodyning unit (6, 96) with the light output of the reference light source (8) for generating the controll signal.

2. Optical frequency generator according to claim 1, characterized by the fact that
the light source of the comb generator (1) is a mode-coupled semiconductor laser (26) with an external resonator (28, 29).

3. Optical frequency generator according to claim 2, characterized by the fact that
the output signal of the frequency transmitter (13) may be superposed on the control current of the semiconductor laser (26) by a laser control circuit (35).

4. optical frequency generator according to claim 2 or 3,
characterized by the fact that
the control current of the semiconductor laser (26) is provided with a portion correlated to the control signal.

5. Optical frequency generator according to one of claims 2 to 4,
characterized by the fact that
the resonator of the semiconductor laser (26) is provided with a reflection grating (29) for adjusting the center frequency.

6. Optical frequency generator according to one of claims 1 to 5,
characterized by the fact that
the optically non-linear component (38) of the comb generator (1) is provided with a light amplifier (39) receiving light output of the light source (26) and a light guide fiber (40) with a dispersion minimum centered about the center frequency of the light source (26), receiving light output from the light amplifier (39).

7. Optical frequency light generator according to one of claims 1 to 6,
characterized by the fact that
the superheterodyning unit (6, 96) is provided with at least one light-sensitive detector (44, 61, 67) receiving light output from the comb generator (1) and light output from the reference light source (8) and a frequency filter (46, 106) and that it has a band width which at a maximum corresponds to the greatest frequency difference between the light output of the reference light source (8) and the light output of the comb generator(1).

8. Optical frequency generator in accordance with claim 7,
characterized by the fact that
the superheterodyning unit (6) ist provided with a comparator circuit (47) that output signal of which ist correlated as a control signal for the deviation of a beat frequency detected by the light-sensitive detector (44) and defference frequency fed to the comparator circuit (47) from a difference frequency generator (48) controllable by the control circuit (10).

9. Optical frequency generator in accordance with claim 7,

characterized by the fact that

a beat frequency signal generated on the light-sensitive detector (61, 67) by superheterodyning the light output of the reference light source (8) and the light output of the comb generator (1) may be fed as a control signal to an electronic control (95) by which a further control signal may be generated for controlling the light source (26).

10. Optical frequency generator according to one of claims 1 to 9.

characterized by the fact that

the light output of the optical frequency generator may be superheterodyne with light output of unknown frequency from a test light source in a superheterodyning receiver (17, 96) with a band width corresponding to at most half the smallest transmission frequency ot the frequency transmitter (13), the output signal of which being correlated as a beat signal for a frequency difference between the light output of the optical frequency generator and the light output of the test light source.

11. Optical frequency generator according to claim 10, characterized by the fact that

the output signal of the superheterodyning receiver (17, 96) may be fed to a frequency meter (22), with which the frequency of the beat signal may be determined and fed to the control electronic (10, 95) as a frequency value.

12. Optical frequency generator according to claim 11, characterized by the fact that

the frequency of the light output of the test light source may be determined absolutely by the control electronic (10, 95) by means of the frequency of the light output of the reference light source (8), the transmission frequency of the frequency generator (13) as well as the displacement frequency being the difference between the frequency of the light output of the reference light source (8) and a frequency component of the light output of the comb generator (1).

**Revendications**

1. Générateur de fréquences optiques, comportant une source de lumière de référence, un émetteur de fréquences (13), un générateur de peigne optique pour créer une pluralité de fréquences optiques, et une électronique de commande, caractérisé en ce que le générateur de peigne (1) présente une source de lumière (26) dont la fréquence peut être modulée par un signal de régulation ainsi que par un signal de sortie de l'émetteur de fréquences (13), dont la fréquence peut être ajustée au moyen de l'électronique de commande (10, 95), et un module optique non linéaire (38) recevant la lumière de sortie de la source de lumière (26), tandis qu'avec la source de lumière (26) et le module optique non linéaire (38), autour d'une fréquence centrale qui peut être ajustée par le signal de régulation, il est possible de créer une pluralité de bandes latérales à des écarts de fréquence qui correspondent à un multiple de la fréquence du signal de sortie délivré par l'émetteur de fréquences (13), et en ce que, pour la création du signal de régulation, la lumière de sortie du générateur de peigne (1) peut être superposée à la lumière de sortie de la source (8) de lumière de référence dans une unité de superposition (6, 96).

2. Générateur de fréquences optiques selon la revendication 1, caractérisé en ce que la source de lumière du générateur de peigne (1) est un laser semi-conducteur (26) en mode couplé présentant un résonateur externe (28, 29).

3. Générateur de fréquences optiques selon la revendication 2, caractérisé en ce que le signal de sortie de l'émetteur de fréquences (13) est appliqué sur le courant de commande du laser semi-conducteur (26) au moyen d'un circuit (35) de commande du laser.

4. Générateur de fréquences optiques selon les revendications 2 ou 3, caractérisé en ce que le courant de commande du laser semi-conducteur (26) présente une partie corrélée au signal de régulation.

5. Générateur de fréquences optiques selon l'une des revendications 2 à 4, caractérisé en ce que le résonateur du laser à semi-conducteur (26) présente une grille de réflexion (29) pour l'établissement de la fréquence centrale.

6. Générateur de fréquences optiques selon l'une des revendications 1 à 5, caractérisé en ce que le module optique non linéaire (38) du générateur de peigne (1) présente un amplificateur de lumière (39) recevant la lumière de sortie de la source de lumière (26) et une fibre optique (40) recevant la lumière de sortie de l'amplificateur de lumière (39), la fibre optique présentant un minimum de dispersion autour de la fréquence centrale de la source de lumière (26).

7. Générateur de fréquences optiques selon l'une des revendications 1 à 6, caractérisé en ce que l'unité de superposition (6, 96) dispose d'au moins un détecteur (44, 61, 67) sensible à la lumière, qui reçoit la lumière de sortie du générateur de peigne (1) et la lumière de sortie de la source (8) de lumière de référence, ainsi que d'un filtre de fréquence (46, 106), et présente une largeur de bande qui correspond au plus au plus grand écart en fréquence entre la lumière de sortie de la source (8) de lumière de référence et la lumière de sortie du générateur de peigne (1).

8. Générateur de fréquences optiques selon la revendication 7, caractérisé en ce que l'unité de superposition (6) présente un circuit comparateur (47) dont le signal de sortie est corrélé à l'écart entre une fréquence de battement détectée par le détecteur (44) sensible à la lumière et une fréquence de différence délivrée comme signal de régulation au circuit comparateur (47) par un générateur de fréquences de différence (48) piloté par le circuit de commande (10).

9. Générateur de fréquences optiques selon la revendication 7, caractérisé en ce qu'avec l'unité de superposition (96), un signal de fréquence de battement créé sur le détecteur (61, 67) sensible à la lumière par superposition de la lumière de sortie de la source (8) de lumière de référence et de la lumière de sortie du générateur de peigne (1), peut alimenter en tant que signal de régulation une électronique de commande (95) avec laquelle un autre signal de régulation pour le pilotage de la source de lumière (26) peut être créé.

10. Générateur de fréquences optiques selon l'une des revendications 1 à 9, caractérisé en ce que la lumière de sortie du générateur de fréquences optiques peut être superposée à la lumière de sortie, de fréquence inconnue, d'une source de lumière à tester, dans un récepteur de superposition (17, 96) dont la largeur de bande correspond au plus à la moitié de la plus petite fréquence émise par l'émetteur de fréquences (13) et dont le signal de sortie est corrélé en tant que signal de battement à une différence de fréquence entre la lumière de sortie du générateur de fréquences optiques et la lumière de sortie de la source de lumière à tester.

11. Générateur de fréquences optiques selon la revendication 10, caractérisé en ce que le signal de sortie du récepteur de superposition (17, 96) peut être introduit dans un compteur de fréquence (22) par lequel la fréquence du signal de battement peut être déterminée et délivrée comme valeur de fréquence à l'électronique de commande (10, 95).

12. Générateur de fréquences optiques selon la revendication 11, caractérisé en ce que la fréquence de la lumière de sortie de la source de lumière à tester peut être déterminée de manière absolue par l'électronique de commande (10, 95), au moyen de la fréquence de la lumière de sortie de la source (8) de lumière de référence, de la fréquence d'émission de l'émetteur de fréquences (13) ainsi que d'une fréquence de dérive, qui est la différence entre la fréquence de la lumière de sortie de la source (8) de lumière de référence et d'une composante de fréquence de la lumière de sortie du générateur de peigne (1).

Fig. 1

EP 0 826 254 B1

**Fig. 2**

EP 0 826 254 B1

Fig. 3

Fig. 4

**72** START

**73** $f_{LO1}$, $\Delta f_{LO}$, $\Delta_{max}$, $\Delta_{min}$, $f_g$, $f_{ref}$, $\Delta f_{ZF}$, $U_s$

**74** $f_{LO} := f_{LO1}$, $\Delta := \Delta_{max}$

**75** $\Delta := \Delta - 2 f_g$

**76** $\Delta < \Delta_{min}$

**77** STOP

**78** $U_{TE} > U_s$ oder $U_{TM} > U_s$

**79** $U_{TE} > U_{TM}$

**80** TE

**81** TM

**Fig. 5**

82 — $f_{ZFA} := f_{ZF}$

83 — $\Delta := \Delta - f_{ZFA}$

84 — $f_{ZFB} := f_{ZF}$

85 —

T     $f_{ZFB} < \Delta f_{ZF}$     F

$\Delta := \Delta + 2 f_{ZFA}$ — 86

87 — $\Delta := \Delta - 0.5 f_{g}$

88 — $f_{ZF1} := f_{ZF}$
$\Delta_{x} := \Delta$

89 — $f_{LO} := f_{LO} + \Delta f_{LO}$

90 — $f_{ZF2} := f_{ZF}$

91 — $N := \mathrm{sign}[\Delta f_{LO}(f_{ZF1} - f_{ZF2})] \cdot$
$\cdot \mathrm{rnd} | (f_{ZF2} - f_{ZF1}) / \Delta f_{LO} |$

92 — $f_{x} := f_{ref} + \Delta_{x} + N \cdot f_{LO1} + f_{ZF1}$

93 — ENDE

**Fig. 6**

Fig. 7

Fig. 8

Fig. 9

EP 0 826 254 B1

**Fig. 10**

Fig. 11

**127** $f_{ZF}$

**88** $f_{ZF1} := f_{ZF}$

**128** $\Delta$

**89** $f_{LO} := f_{LO1} + \Delta f_{LO}$

**129** $\Delta_A := \Delta$

**131** $f_r := f_r - v_2 \cdot (\Delta_A - \Delta_x)$

**130** $|\Delta_x - \Delta_A| < \Delta\Delta_x$  F

T

**132** $f_{ZF}$

**90** $f_{ZF2} := f_{ZF}$

**133**
$$N := v_1 \cdot sign[\Delta f_{LO}\,(f_{ZF1} - f_{ZF2})] \cdot$$
$$\cdot rnd|(f_{ZF2} - f_{ZF1})/\Delta f_{LO}|$$

**134** $f_x := f_{ref} + v_2 \cdot \Delta_x + N \cdot f_{LO1} + v_1 \cdot f_{ZF1}$

**93** ENDE

**Fig. 12**